(19) **Europäisches Patentamt / European Patent Office / Office européen des brevets**

(11) **EP 3 993 204 B1**

(12) **EUROPEAN PATENT SPECIFICATION**

(45) Date of publication and mention
of the grant of the patent:
**27.09.2023 Bulletin 2023/39**

(21) Application number: **20204229.7**

(22) Date of filing: **28.10.2020**

(51) International Patent Classification (IPC):
*H02H 3/04* *(2006.01)*          *H02H 3/40* *(2006.01)*
*H02H 3/52* *(2006.01)*

(52) Cooperative Patent Classification (CPC):
**H02H 3/52; H02H 3/042; H02H 3/40**

(54) **DETERMINING A FAULT LOCATION ON A POWERLINE**

BESTIMMEN EINES FEHLERORTES AUF EINER STROMLEITUNG

DÉTERMINATION DE LA LOCALISATION D'UN DÉFAUT SUR UNE LIGNE ÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.05.2022 Bulletin 2022/18**

(73) Proprietor: **Katholieke Universiteit Leuven
3000 Leuven (BE)**

(72) Inventors:
  • **BAECKELAND, Nathan
    9040 Sint-Amandsberg (BE)**
  • **KLEEMAN, Michael
    9040 Sint-Amandsberg (BE)**

(74) Representative: **Winger
Mouterij 16 bus 101
3190 Boortmeerbeek (BE)**

(56) References cited:
  EP-A1- 3 726 681          WO-A1-2015/145170
  WO-A1-2019/229638          US-A1- 2018 203 056

## Description

## Technical field of the invention

The present invention relates to determining a fault location on a powerline. More concretely, the present invention relates to a method for determining the fault location, and to an apparatus comprising means to execute the method to determine the fault location. Further, the invention relates to a converter comprising the circuit element and relates to

a computer comprising means for carrying out the steps of the method.

## Background of the invention

Electricity grids form a vital part of infrastructure of modern society. Therefore, the electricity grids must operate safely and reliably. However, electricity grids are constantly exposed to threats. For example, dredging works may damage underground cables, and storms may cause trees to fall into overhead lines. These events lead to unavoidable faults that the electricity grid must cope with. Protection systems and utility crews may aid in coping with the faults. For instance, in a first step, a protection system may isolate the fault within a few milliseconds so that the rest of the grid remains supplied. Next, in a second step, a utility crew restores the faulted part by e.g. repairing an underground cable. For both steps it is vital to properly locate the fault.

In the state of the art, several types of methods are implemented to locate faults in electricity grids. One type of methods tries to locate the fault by determining an impedance, that is, by employing an algorithm that calculates the fault impedance. When a fault occurs, the calculated impedance is proportional to the distance to the fault. Therefore, we use the term fault distance calculation. With this fault distance calculation, the location of the fault may be determined.

Fault distance calculations are put into practice in two ways. First, real-time fault distance calculation is used in so-called protective relays. These relays are part of the protection system. They locate the fault in a few milliseconds and control a circuit breaker that isolates the fault. Second, fault distance calculation is used as an offline diagnostic tool. The calculation is deployed on the computer of a network control centre. There, it informs the utility crew about the fault location so that the restauration works can be planned.

Traditional fault distance calculation uses the measured voltages and currents following the law of Ohm for alternating current. With that, an accurate fault distance calculation is possible: The impedance is proportional to the length of the line, which makes the fault distance proportional to the fault impedance. Traditional distance calculation has proven reliable because electricity grids are dominated by the synchronous generators of thermal power plants. These synchronous generators behave as voltage sources during faults which is the base of the fault impedance calculation described above. However, with the increasing uptake of renewable energies such as wind and solar power, traditional distance calculation becomes unreliable. The reason is that renewable energy sources employ power electronic converters. The behaviour of converters is significantly different than the behaviour of synchronous generators during faults.

Indeed, converters are very flexible in the way they behave during faults. The behaviour of converters is to a large extend programmable. As an example, the converter can be programmed in such a way that the fault current is limited to a given threshold that depends on the voltage. In contrast, the fault behaviour of synchronous generators is a result of a few construction parameters, such as excitation voltage and rated power, following fundamental principles of physics. Current research has shown that converters cause malfunction of traditional methods and traditional protection systems i.e. of protective systems of the state of the art. In C. Brantl et al., "The Application of Line Protection Relays in High Voltage AC Transmission Grids Considering the Capabilities and Limitations of Connected MMCs," Developments in Power System Protection (2020) Proceedings, 2020, pages 1-6, the performance of traditional protection systems that were confronted with power electronic converters was investigated. In all simulated cases, the traditional protection system failed to locate a fault. A similar study on the influence of converter control systems on distance protection can be found in A. Hooshyar et al., "Distance Protection of Lines Emanating from Full-Scale Converter-Interfaced Renewable Energy Power Plants-Part I: Problem Statement," IEEE Trans. Power Deliv., vol. 30, no. 4, 2015, pages 1770-1780. In E. Martinez et al., "Effects of Type-4 Wind Turbine on present protection relaying algorithms," Ninth Protection, Automation and Control (PAC) World Conference, 2018, protective relays of the state of the art from different manufacturers were tested in an electricity grid entirely fed by power electronic converters: The results show that up to half of the faults remained undetected or were wrongly located, which ultimately led to a malfunction of the protection system.

WO2015/145170 and US2018/203056, similar to the present invention, estimate different locations of the fault based on voltage on a powerline and a current through the powerline.

There is therefore a need in the art for a method and/or a protection system for accurately determining a fault location in an electricity grid, even if the electricity grid is connected to a power source comprising a converter.

## Summary of the invention

It is an object of the present invention to provide good apparatus and methods for determining a location of a fault on a powerline in an electricity grid. It is an advantage of embodiments of the present invention that limitations of traditional fault distance calculation may be overcome: in particular, a fault location may be accurately determined even on powerlines connected to generators comprising power electronic converters. Furthermore, embodiments of the present invention provide an accurate determination of the fault location regardless of the control system used by the converters. It is an advantage of embodiments of the present invention that the method and apparatus may be used in any type of powerline, that is, in both overhead lines and cables. A further advantage is that communication e.g. between multiple measurement locations is not required, as only time dependent data acquired at a single measurement location, wherein the measurement location is e.g. at the end of the line, is required to determine a fault location.

The above objective is accomplished by a method according to claim 1, a circuit element according to claim 9, a converter according to claim 13 and a computer according to claim 14.

According to a first aspect, the present invention relates to a method for determining a location of a fault, having a fault type, on a powerline that is at a first end connected to an electricity grid and at a second end to a power source for applying an alternating electrical signal with a fundamental frequency to the line. The method comprises: a) obtaining, using a measuring device at a measurement location on the powerline, time-dependent data of a voltage on the powerline and of a current through the powerline at the measurement location, wherein the time-dependent data is obtained during a time period after fault inception, wherein the time-dependent data comprises fundamental and nonfundamental frequency waveform components, and wherein a duration of the time period is at least a duration of one full period of the fundamental frequency; b) removing the fundamental frequency components from the time-dependent data; c) calculating, from the time-dependent data, a virtual fault inductance for at least two different potential fault locations, by inputting the time-dependent data into an equivalent circuit model suitable for the fault type, and by means of time-domain calculations on the nonfundamental frequency waveform components; and d) deriving, from the virtual fault inductance for each of the potential fault locations, a location on the line at which the virtual fault inductance is substantially zero.

The connection between the powerline and the electricity grid and between the powerline and the power source may be a direct connection, or may be an indirect connection. In the indirect connection, for instance, a further electrical element may be present between the power source and the powerline, or between the powerline and the grid, such as, but not limited to, a transformer.

The powerline connects the power source to the electricity grid. Typically, the electricity grid comprises synchronous generators that generate an alternating electrical signal at the fundamental frequency. That is, in embodiments, both the power source connected to the second end of the powerline, and the synchronous generator in the grid, generate an alternating electrical signal at the fundamental frequency. The powerline is typically a three-phase powerline, that is, wherein the powerline comprises three conductive wires. Typically, an alternating electrical signal of each wire has a phase shifted by $2/3\pi$ radians i.e. 120 degrees with respect to the phase of an alternating electrical signal through the other wires. In embodiments, in step a) the time-dependent data of three phases of the voltage and the current is obtained. Advantageously, using the waveforms of the three phases allows to determine the fault location in a three-phase electrical circuit. The fault type may be any type of fault that may occur in such a powerline, such as, but not limited to: an open-circuit fault, wherein current is blocked in the powerline; a ground fault in which current flows from at least one of the wires of the powerline into the ground; a three-phase fault, wherein the three phases of the powerline are short-circuited together; a phase-to-phase fault, wherein two phases of the powerline are short-circuited together; or a phase-to-ground fault, wherein one phase is short-circuited to the ground.

The location of the fault may be a location on the powerline where at least one wire of the powerline or insulation around at least one wire of the powerline is damaged. As a result, as an example, current through at least one of the wires of the powerline may flow out of the wire into a ground at the fault location, may flow between wires of the powerline, or may be blocked in the wire at the fault location.

The power source may comprise any type of power source, such as a synchronous generator of a thermal power plant, or a generator, i.e. power source, comprising a power electronic converter. Indeed, although the method of the first aspect may be suitable for use with any power source, embodiments of the method are particularly well-suited for application to power sources comprising a converter. In embodiments, the power source is a power source comprising the converter. In embodiments, the power source comprising the converter may comprise a sustainable energy power source, such as a wind turbine, photovoltaic cells, a hydroelectric plant, batteries or a fuel-cell. The converter i.e. a voltage source converter may for instance comprise a direct current bus with electrolytic capacitors, three legs and in total 6 insulated gate bipolar transistors (IGBTs).

The alternating electrical signal comprises the voltage waveform and the current waveform. The fundamental frequency of the alternating electrical signal generated by the power source is typically substantially constant, i.e. is similar before, during, and after fault inception. In embodiments, the fundamental frequency may be of any frequency, but is typically 50 Hz or 60 Hz. In embodiments, when there is no fault on the line, the signal on the powerline substantially consists of the fundamental frequency.

In an embodiment not part of the invention, the fault current and voltage of the grid may be entirely different in phase and magnitude. However, the grid is build out of synchronous generators and these do not actively inject harmonics into the grid

In an embodiment part of the invention, during a transient period after fault inception, wherein the fault inception is a moment in time wherein the fault occurs, in addition to the fundamental frequency, also transient nonfundamental frequency components may be present in the electrical signal, i.e. in the voltage waveform and the current waveform. In embodiments, the nonfundamental frequency components comprise or consist of harmonic nonfundamental frequency components, that is, wherein a frequency of any harmonic nonfundamental frequency component is equal to the fundamental frequency multiplied by an integer, wherein the integer equals at least 2. However, the method of the present invention is not limited to nonfundamental frequency components comprising or consisting of harmonic nonfundamental frequency components. Without being bound by theory, the nonfundamental frequency components result from a transition from a state wherein the powerline does not comprise the fault to a state wherein the powerline comprises the fault, resulting in a sudden change in voltage at the location of the fault. After a certain time period, depending on time constants of the powerline and the grid, the nonfundamental frequency components fade out. In case power electronic converters are connected to the powerline or the grid, additional nonfundamental frequency components will be injected into the grid due to non-linear behaviour of the converter, wherein the converter will limit current injection to prevent internal damage.

The measuring device at the measurement location may be any type of device suitable for obtaining time-dependent data of the voltage on the powerline and of the current through the powerline at the measurement location, typically voltage- and current-transformers. The measurement location is somewhere on the powerline, that is, between the power source and the electricity grid, preferably located as close as possibly to the power source. In embodiments, when the power source comprises a converter, the converter comprises the measuring device. In such embodiments, the measuring device may be located close to or at the second end of the powerline.

The time-dependent data at least cover a time period that has a duration of one full period of the fundamental frequency. Advantageously, the one full period of the fundamental frequency may be a sufficiently long time period to determine the fault location. Furthermore, in embodiments, the time-dependent data comprises a time resolution of at least 1 ms. Advantageously, in embodiments, by using at least this time resolution, the waveform is sufficiently accurate to determine the fault location. Furthermore, this resolution allows to acquire harmonics of up to 500 Hz, which is at a considerably higher frequency than the fundamental frequency of the alternating electrical signal generated by synchronous power sources in contemporary electricity grids, that typically have a frequency of 50 Hz or 60 Hz. Also, it is a technically feasible time resolution for the state of the art, as many measurement devices may reach such a resolution.

In an embodiment of the invention, step b) of removing the fundamental frequency component may be performed by any method suitable for removing the fundamental frequency component, while keeping, at the same time, the nonfundamental frequency components intact. Suitable methods for removing the fundamental frequency component may comprise an analogue high-pass filter of second order or higher using an operation amplifier circuit or a digital high-pass filter employing, for instance, a finite-impulse filter (FIR) or infinite impulse filter (IIR) or a Fast Fourier transform.

The equivalent circuit model depends on the fault type, as electrical connections induced by the fault e.g. between the wires of the powerline also depend on the fault type. In embodiments, the equivalent circuit model has equivalent electrical characteristics as the real circuit, but is, in comparison, simplified to facilitate and speed up calculation of the virtual fault inductance. In embodiments, the equivalent circuit model used for calculating the virtual fault impedance may not comprise a voltage and/or current source for the power source or for a synchronous power source in the electricity grid. Power sources generate an electrical signal alternating at the fundamental frequency. However, as the time-dependent data used for the calculations consists of nonfundamental frequency components, a voltage source may be ignored in the equivalent circuit model. Advantageously, because only the nonfundamental frequency components are considered, no information is required about the power source that is connected to the powerline or about the synchronous power source to the electricity grid.

In an embodiment of the invention, the potential fault location may be any location on the line. In embodiments, calculating the virtual fault inductance using the equivalent circuit model comprises calculating an inductance induced by the fault at the potential fault location. Faults are typically purely resistive, so that the inductance at the fault location may be assumed to be strictly zero. In contrast, the virtual fault inductance that is calculated for the potential fault location may be, but is not necessarily, zero: indeed, the virtual fault inductance is only zero if the potential fault location is at the true fault location. In embodiments, the virtual fault inductance is virtual in the sense that it can be calculated for any potential fault location in step c) but that it actually does not exist and therefore is zero at the true fault location.

The time-domain calculations for calculating the virtual fault inductance may be performed by any mathematical method suitable for calculating an inductance in the equivalent circuit model. In this equivalent circuit model, the fault is modelled as a resistance in series with the virtual fault inductance that short-circuits one phase of the powerline at the fault location with another phase or the ground, depending on the type of the fault. The aim of the calculations is to determine the fault resistance and the virtual fault inductance so that these match the measured time dependent data and voltage. In embodiments, the type of time-domain calculations used for calculating the virtual fault inductance depend on the equivalent circuit model i.e. on the fault type. Advantageously, calculating the virtual fault inductance is performed in the time-domain, not in the frequency-domain. A drawback of calculations in the frequency-domain would be that to extract frequency components from a signal, the time domain needs to have a minimum timespan. For low harmonics, e.g. the third or fifth harmonic, this is a significant timespan. For fast changing transient signals such as those during the transient period directly after fault inception, this may pose problems to obtain stable and correct frequency information. Furthermore, harmonic content depends on the situation and varies in time. To overcome all these difficulties when working in the frequency-domain when considering transient waveforms, in the method of the present invention, time-domain calculations are performed. In embodiments, the time-dependent data comprises time series data of the voltage and the current acquired over the time period, and the time-domain calculations of step c) comprise discrete time-domain calculations. Advantageously, by using discrete time-domain calculations, sampled i.e. obtained time-dependent data can be directly used, instead of first performing time series data analysis and/or waveform fitting.

According to the present invention, a location on the line is derived, from the virtual fault inductances at the potential fault locations, at which the virtual fault inductance is substantially zero. In embodiments, the closer the virtual fault inductance is to zero, the better may be the accuracy of the derived location of the fault, that is, the closer the location of the fault derived by the method of the first aspect may be to the real location of the fault. In embodiments, "substantially zero" means that the virtual fault inductance is smaller than 5%, preferably smaller than 1 %, of the inductance of the powerline, and is most preferably equal to zero.

In an embodiment of the invention, deriving the location of the fault comprises fitting a fit curve to the virtual fault inductance as a function of the potential fault location on the line, thereby yielding the location at which the virtual fault inductance equals substantially zero. Advantageously, curve fitting, such as by using a polynomial fit curve, is a very simple and fast way to accurately determine the location on the powerline where the virtual fault inductance equals zero, even if the virtual fault inductance was calculated only for a small amount of, such as at least two, potential fault locations. In embodiments, for the more potential fault locations the virtual fault inductance is calculated, the more accurate determining the fault location by the curve fitting may be.

In an embodiment of the invention, the time-dependent data comprises recorded time-dependent data from historical events. Advantageously, exploiting historical recorded time-dependent data allows a post-mortem analysis. In embodiments, such an analysis may be performed offline after a fault has occurred in the grid. The post-mortem analysis may furthermore comprise calculating the fault location by using time-dependent data acquired by multiple measuring devices at multiple measuring locations on the powerline. Comparing the fault location determined based on time-dependent data recorded at multiple measurement locations on the line may yield a more accurate determination of the fault location.

According to a second aspect, the present invention relates to a circuit element for determining a location of a fault, having a fault type, on a powerline connected to an electricity grid. The circuit element comprises an acquisition system configured for obtaining time-dependent data of a voltage on the powerline and of a current through the powerline at a measurement location on the powerline, during a time period after fault inception, wherein the time-dependent data comprises fundamental and nonfundamental frequency waveform components, and wherein a duration of the time period is at least a duration of one full period of the fundamental frequency. The circuit element further comprises a means configured for determining the fault type. The circuit element further comprises a processing device configured for performing the steps of: removing the fundamental frequency components from the time-dependent data; calculating, from the time-dependent data, a virtual fault inductance for at least two different potential fault locations, by inputting the time-dependent data into an equivalent circuit model suitable for the fault type, and by means of time-domain calculations on the nonfundamental frequency waveform components; and deriving, from the virtual fault inductance for each of the potential fault locations, a location on the line at which the virtual fault inductance is substantially zero.

A circuit element may advantageously be located at a location on the line, so that the time between fault inception and determining the location of the fault may be minimized. In an embodiment of the invention, the circuit element comprises means for controlling a circuit breaker. Advantageously, the circuit element may act in response to determining a fault location, for instance by isolating the part of the line comprising the fault location. When the circuit element is located on the line, isolating may be performed very fast after fault inception.

In an embodiment not part of the invention, the acquisition system may comprise an analogue interface with voltage- and current transformers and an analogue-digital conversion unit or a digital interface to a process bus to receive sampled values. In embodiments, obtaining time-dependent data comprises detecting i.e. measuring e.g. sampling the voltage on the powerline and the current through the powerline. In embodiments, the acquisition system comprises means for direct connected to the powerline. In embodiments, the acquisition system is communicatively coupled to the processing device for transfer of the obtained time-dependent data from the acquisition system to the processing device.

In an embodiment not part of the invention, the means configured for determining the fault type may comprise, for instance, faulted phase selection based on voltage imbalance or symmetrical components of currents. In embodiments, the means configured for determining the fault type is communicatively coupled to the processing device for transfer of the obtained time-dependent data from the acquisition system to the processing device.

In an embodiment not part of the invention, the processing device may comprise a microprocessor, and/or a digital signal processor, and/or a field programmable gate array. In embodiments, the processing device comprises a memory for storing instructions for performing the steps the processing device is configured for. In embodiments, the processing device further comprises means for obtaining the time-dependent data from the acquisition system. The time-dependent data communicated by the acquisition system to the processing device may be directly processable by the processing device. In an embodiment not part of the invention, an analogue-to-digital converter may be present communicatively between the acquisition system and the processing device. Advantageously, the analogue-to-digital converter may convert an analogue signal from the acquisition system into data in a binary number system that may be processed by the processing device. In an embodiment not part of the invention, the processing device further comprises means for obtaining the fault type from the means configured for determining the fault type.

In an embodiment not part of the invention, the circuit element comprises a communication system for communicating the determined location of the fault. In embodiments, the communication system comprises a communication protocol converter and a physical link to a fibre-optic wide area network. Advantageously, if the powerline comprises multiple circuit elements, the determined location of the fault from different circuit elements may be communicated to a central location e.g. to a computer, or to a circuit element further comprising means for comparing the locations of the fault determined by multiple circuit elements, for comparing the locations of the fault determined by multiple circuit elements. In embodiments, the circuit element comprising the communication system further comprises a processor for determining the fault location using at least two determined locations of the fault. Due to measurement errors and, furthermore, simplifications in the equivalent circuit model with respect to the real electrical circuit, the method will bear errors in the fault location estimation. Comparing the estimations from several circuit elements that carry out the method reduces these errors and yields a more precise fault location estimation. In an embodiment not part of the invention, the communication system may be performed via a data transfer cable or via a wireless connection e.g. for communicating via 4G or 5G cell-phone network.

In an embodiment not part of the invention, the circuit element further comprises a communication system for communicating the time-dependent data. The communication system for communicating the time-dependent data comprises transferring the time-dependent data to a computer that is located externally, such as in a network control centre. Advantageously, by communicating the time-dependent data to an external computer, the time-dependent data may be stored and used for post-mortem analysis of the fault, e.g. by performing embodiments of the method of the first aspect on the time-dependent data saved on the computer.

According to a third aspect, the present invention relates to a converter comprising a circuit element according to embodiments of the second aspect of the present invention. Typically, the converter of a generator comprises sensors that may be used as acquisition system of the circuit element. Therefore, when the circuit element is comprised in the converter of a generator, the amount of equipment required for determining a location of a fault is minimized. Furthermore, the converter comprises power electronic switches, which may be used as a circuit breaker. Therefore, in an embodiment of the invention, wherein the circuit element comprises means for controlling the circuit breaker, no additional circuit breaker is required to isolate the fault, so that the amount of equipment required for isolating the fault is minimized.

According to a fourth aspect, the present invention relates to a computer comprising means for carrying out the steps of the method according to embodiments of the first aspect of the present invention.

Advantageously, the computer, for instance the computer of a network control centre, may comprise software to very accurately calculate the fault location from the time-dependent data. Indeed, as the computer may comprise more computational power than a circuit element, the fault location may be determined more accurately than that determined by the circuit element.

In embodiments, the computer comprises means for communicating with a circuit element according to any embodiment of the second aspect. In an embodiment not part of the invention, the means for communicating may e.g. comprise a fibre-optic wide area network employing an IEC60870 communication protocol. This facilitates transfer of determined fault locations and/or time-dependent data from the circuit element to the computer. Advantageously, this improves a rate at which fault locations determined by the circuit element and/or time-dependent data obtained by the circuit element may be transferred from the circuit element to the computer. Furthermore, determined fault locations and/or obtained time-dependent data may in this way be easily stored for post-mortem analysis.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

FIG. 1 is a schematic representation of a circuit topology, comprising a powerline, a measuring device, an electricity grid, and a power source comprising a converter.

FIG. 2 is a symbol circuit diagram of an equivalent circuit model that may be used in embodiments of the first aspect of the present invention if the fault type is a three-phase fault.

FIG. 3A and FIG. 3B are symbol circuit diagrams of an equivalent circuit model that may be used in embodiments of the first aspect of the present invention if the fault type is a three-phase fault.

FIG. 4 is a graph of a virtual fault inductance versus location on a powerline.

FIG. 5 is a symbol circuit diagram of an equivalent circuit model that may be used in embodiments of the first aspect of the present invention if the fault type is a phase-to-phase fault.

FIG. 6 is a schematic representation of a circuit topology comprising a circuit element according to an embodiment of the second aspect of the present invention.

FIG. 7 is a schematic representation of a circuit element according to embodiments of the second aspect of the present invention comprising a hard-wired connection.

FIG. 8 is a schematic representation of a circuit element comprising a busbar according to embodiments of the second aspect of the present invention comprising a process-bus.

FIG. 9 is a schematic representation of a circuit topology comprising a converter according to embodiments of the third aspect of the present invention.

FIG. 10 is a schematic representation of a converter according to embodiments of the third aspect of the present invention.

FIG. 11 is a schematic representation of a network control centre comprising a computer according to embodiments of the fourth aspect of the present invention.

**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used.

It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

According to a first aspect, the present invention relates to a method for determining a location of a fault, having a fault type, on a powerline that is at a first end connected to an electricity grid and at a second end to a power source for applying an alternating electrical signal with a fundamental frequency to the line. The method comprises: a) obtaining, using a measuring device at a measurement location on the powerline, time-dependent data of a voltage on the powerline and of a current through the powerline at the measurement location, wherein the time-dependent data is obtained during a time period after fault inception, wherein the time-dependent data comprises fundamental and nonfundamental frequency waveform components, and wherein a duration of the time period is at least a duration of one full period of the fundamental frequency; b) removing the fundamental frequency components from the time-dependent data; c) calculating, from the time-dependent data, a virtual fault inductance for at least two different potential fault locations, by inputting the time-dependent data into an equivalent circuit model suitable for the fault type, and by means of time-domain calculations on the nonfundamental frequency waveform components; and d) deriving, from the virtual fault inductance for each of the potential fault locations, a location on the line at which the virtual fault inductance is substantially zero.

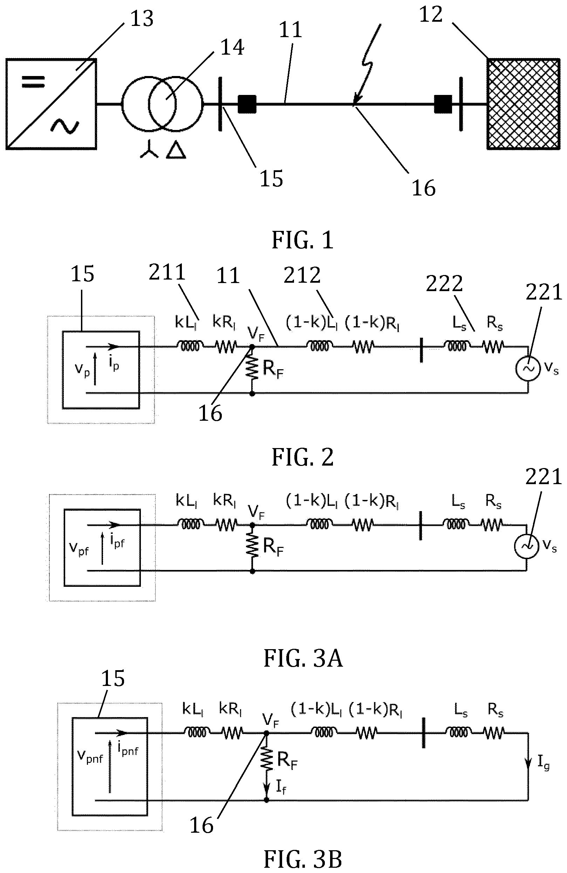

As an example of an embodiment of the first aspect, reference is made to FIG. 1, which shows a circuit topology comprising a powerline 11 with a measuring device 15 on the powerline 11, wherein the powerline 11 is connected at a first end to an electricity grid 12, and at a second end, via a wye-delta transformer 14, to a power source comprising a converter 13. The measuring device 15, located substantially at the second end of the powerline 11, obtains time-dependent data of a voltage on the powerline 11 and of a current on the powerline 11. In the method of the first aspect of the present invention, the measuring device 15 obtains time-dependent data at the measuring location.

In this example, at fault inception, a fault of the three-phase fault type with a fault resistance occurs at a fault location 16 on the powerline 11. The ratio of the distance between the measuring device 15 and the fault location 16 to the total length of the powerline is in this example expressed by a factor k. Therefore, the factor k is proportional to the fault distance. The factor k may be determined by embodiments of the method of the first aspect, which thereby yields the location of the fault on the powerline.

Reference is made to FIG. 2, where part of the circuit topology of FIG. 1 is represented by an equivalent circuit model. The electricity grid is represented by a synchronous voltage source 221 in series with an impedance 222, wherein the impedance 222 comprises an inductance Ls and a resistance Rs. The powerline 11, which connects the measuring device 15 at the measurement location with the grid, has an impedance comprising an inductance $L_l$ and a resistance $R_l$. The powerline 11 is divided in two parts by the fault location 16. Therefore, the powerline comprises a first part with a first impedance 211, and a second part with a second impedance 212, wherein the impedance of the first part and of the second part is proportional to the length of each part. Finally, the fault at the fault location 16, that is purely resistive, has a fault resistance $R_F$.

In the method of the first aspect of the present invention, the fundamental frequency components are removed from the time-dependent data obtained by the measuring device. Removing the fundamental frequency components may facilitate calculations on the equivalent circuit model, for the reason explained in the following text. It follows from Fourier analysis and superposition principles that the equivalent circuit model of FIG. 2 is equivalent to the sum of two separate equivalent circuit models. In the present example, the equivalent circuit model is divided into a fundamental frequencies equivalent circuit model, comprising an electrical signal alternating at the fundamental frequency, shown in FIG. 3A, and a nonfundamental frequencies equivalent circuit model comprising an electrical signal alternating at nonfundamental frequencies, shown in FIG. 3B. In the nonfundamental frequencies equivalent circuit model, the voltage source, which only generates an electrical signal at the fundamental frequency, is absent. The method of the first aspect of the present invention only considers performing calculations on the nonfundamental frequency components of the time-dependent data: these calculations may therefore be performed in this example on the nonfundamental frequencies equivalent circuit model of FIG. 3B.

The nonfundamental frequencies equivalent circuit model may not be solvable analytically since both the factor k and the fault resistance $R_F$ have an unknown value. Instead, in embodiments according to the method of the first aspect of the present invention, a virtual fault inductance is calculated for multiple different potential fault locations, or equivalently, for different values of the factor k. The virtual fault inductance for the present example may be calculated by an algorithm that is described below - however, the person skilled in the art will realise that also other ways of calculating the virtual fault inductance may be used.

In this example, for all different values of the factor k, the time-dependent voltage at the potential fault location $v_F(t)$ in the nonfundamental frequencies equivalent circuit model can be expressed by:

$$v_F(t) = v_{pnf}(t) - k \cdot \left( R_l \cdot i_{pnf}(t) + L_l \cdot \frac{di_{pnf}(t)}{dt} \right) \qquad (1)$$

wherein t is the time, $v_{pnf}(t)$ is the time-dependent data of the voltage at the measuring location consisting of the nonfundamental frequency components, and $i_{pnf}(t)$ is the time-dependent data of the current at the measuring location consisting of the nonfundamental frequency components. However, as the obtained time-dependent data are time-series data, equation (1) is preferably expressed discretely. In that case, the time-dependent voltage at the potential fault location, comprising time-series data comprising data points n, may be expressed as:

$$v_F(n) = v_{pnf}(n) - k \cdot \left( R_l \cdot i_{pnf}(n) + L_l \cdot \frac{i_{pnf}(n) - i_{pnf}(n-1)}{T_s} \right) \qquad (2)$$

wherein $v_{pnf}(n)$ is the nonfundamental frequency voltage at data point n, $i_{pnf}(n)$ is the nonfundamental frequency current at data point n, and $T_s$ is the time interval between subsequent data points, subsequent with respect to time, in the time-dependent data.

Furthermore, the time-dependent voltage at the potential fault location can be expressed as a function of the time-dependent source current $i_s(t)$:

$$v_F(t) = R_{eq} \cdot i_s(t) + L_{eq} \cdot \frac{di_s(t)}{dt} \qquad (3)$$

where

$$R_{eq} = (1 - k)R_l + R_s \qquad (4)$$

$$L_{eq} = (1 - k)L_l + L_s$$

From equation (3), the time-dependent electricity grid current $i_g$ consisting of nonfundamental frequency components can be expressed in a discrete manner as:

$$i_g(n) = \frac{1}{L_{eq} + \dfrac{R_{eq} \cdot T_s}{2}} \qquad (5)$$

$$\cdot \left( (v_F(n) + v_F(n\text{-}1)) \frac{T_s}{2} + \left( L_{eq} - \frac{R_{eq} \cdot T_s}{2} \right) \cdot i_g(n - 1) \right)$$

The time-dependent virtual fault current if (virtual in the sense that it is the current within the assumption that the fault is at the potential fault location) through the fault impedance at the potential fault location can be expressed as

$$i_F(t) = i_{pnf}(t) - i_g(t) \qquad (6)$$

Finally, from the virtual current $i_F$ of equation (6) and the voltage $v_F$ of equation (3), the virtual fault resistance $R_{Fv}$ (which is virtual in the sense that it is a resistance assuming that the fault is at the potential fault location) and the virtual fault inductance $L_F$ can be calculated:

$$v_F(t) = R_{Fv} \cdot i_F(t) + L_F \cdot \frac{di_F(t)}{dt} \qquad (7)$$

This equation can be solved discretely with equation (8), using at least three time-dependent data points n obtained by the measuring device:

$$\begin{bmatrix} i_F(n\text{-}1) - i_F(n\text{-}2) & \dfrac{i_F(n\text{-}1) + i_F(n\text{-}2)}{2} \cdot T_s \\ i_F(n) - i_F(n\text{-}1) & \dfrac{i_F(n) + i_F(n\text{-}1)}{2} \cdot T_s \end{bmatrix} \cdot \begin{bmatrix} L_F(n) \\ R_{Fv}(n) \end{bmatrix} \qquad (8)$$

$$= \begin{bmatrix} \dfrac{v_F(n\text{-}1) + v_F(n\text{-}2)}{2} \cdot T_s \\ \dfrac{v_F(n) + v_F(n\text{-}1)}{2} \cdot T_s \end{bmatrix}$$

For every value of k, equation (8) will provide a different array of values for the virtual fault inductance $L_F$ and the virtual fault resistance $R_{Fv}$. However, it is known that faults are almost purely resistive, that is, the inductance at the fault location may be assumed to be substantially zero. To find the distance to the fault, $L_F$ and $R_{Fv}$ are calculated for the multiple values of k. The distance to the fault corresponds to the value of the factor k where $L_F$ is substantially, or equal to, zero.

Next, to test the above algorithm, a simulation is performed on the nonfundamental frequencies equivalent circuit model, wherein a three-phase fault has been applied at 75% of the powerline with a fault resistance of $R_F = 2$ ohm. In the simulation, the time-dependent current and the time-dependent voltage are calculated at the measurement location. Subsequently, the fundamental frequency component of the time-dependent data is removed. The time-dependent data, consisting of nonfundamental frequency components, is inputted in the algorithm to calculate the virtual fault inductance for different values for the factor k.

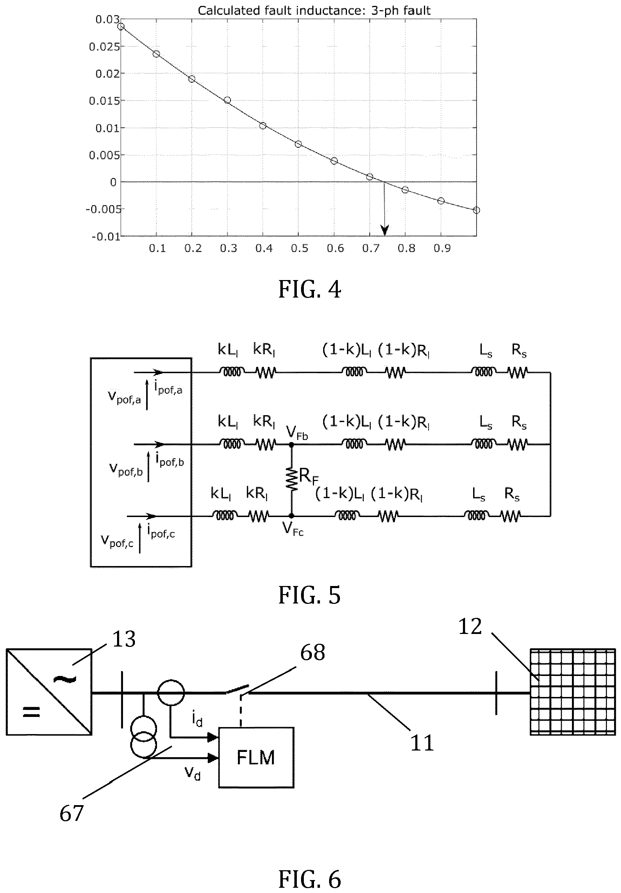

Reference is made to FIG. 4, in which the black circular markers are the virtual fault inductance calculated as a function of k. To find the value for k at which the virtual fault inductance is equal to zero, curve fitting is applied to the calculated virtual fault inductances, wherein the black line is the fitted curve. The fit curve equals zero at k = 0.75. The algorithm thus determines that the fault location is at 75% of the line, which is precisely the location where the fault has been applied in the transient simulation. In addition, the equation (8) yields the fault resistance i.e. which is the virtual fault resistance at k = 0, which may yield insight in the severity and cause of the fault.

Reference is made to FIG. 5, which shows, as a further example not part of the invention, an equivalent circuit model that may be used for calculating a location of a fault in a powerline, using a method according to embodiments of the first aspect of the present invention, in the case the fault type is a phase-to-phase fault. In the case of such a fault, time-dependent data on a voltage and a current must be obtained for each of the three wires of the powerline, i.e. with respect to the voltage, $v_{pof,a}$, $v_{pof,b}$, and $v_{pof,c}$ should be obtained, and with respect to the current, $i_{pof,a}$, $i_{pof,b}$, and $i_{pof,c}$ should be obtained, to determine the fault location using the method of the present invention. For each of the time-dependent data, independently, a fundamental frequency component is removed. The equivalent circuit model comprises, also in this case, no voltage source, as the time-dependent data used for the calculations of the fault type consist of nonfundamental frequency components.

Although in the above examples, a three-phase fault and a phase-to-phase fault are considered, the invention is not limited to these types of faults, and any type of fault may be considered.

According to a second aspect, the present invention relates to a circuit element for determining a location of a fault, having a fault type, on a powerline connected to an electricity grid. The circuit element comprises an acquisition system configured for obtaining time-dependent data of a voltage on the powerline and of a current through the powerline at a measurement location on the powerline, wherein the time-dependent data is obtained during a time period after fault inception, wherein the time-dependent data comprises fundamental and nonfundamental frequency waveform components, and wherein a duration of the time period is at least a duration of one full period of the fundamental frequency. The circuit element further comprises a means configured for determining the fault type, and a processing device configured for performing the steps of: removing the fundamental frequency components from the time-dependent data; calculating, from the time-dependent data, a virtual fault inductance for at least two different potential fault locations, by inputting the time-dependent data into an equivalent circuit model suitable for the fault type, and by means of time-domain calculations on the nonfundamental frequency waveform components; and deriving, from the virtual fault inductance for each of the potential fault locations, a location on the line at which the virtual fault inductance is substantially zero.

As an example of the second aspect of the present invention, FIG. 6 is a schematic representation of a circuit topology, comprising a powerline 11, a circuit element 67 according to an embodiment of the second aspect of the present invention, an electricity grid 12, and a power source comprising a converter 13.

The circuit element 67 e.g. a protective relay comprises means to communicate with a circuit breaker 68 on the powerline 11. The purpose is to protect the powerline 11 connecting the power source comprising the converter 13, for instance a wind power plant, to an electricity grid 12. The method for determining a fault location according to embodiments of the first aspect of the present invention offers the benefit that protection at a distance becomes possible using existing protective relay technology. In contrast, methods of the state of the art fail in such a case, due to the influence of the converter on the electrical signal, so that more expensive protection concepts, such as current differential protection, are needed to achieve a great safety of supply.

In this example, the circuit element 67 is installed in the proximity of the power source comprising the converter 13. An acquisition system of the circuit element 67 acquires time-dependent data on the voltage ($v_d$) on, and current ($i_d$) through, the powerline 11. For this, an instrument transformer may be present between the powerline 11 and the acquisition system: instrument transformers convert i.e. reduce magnitude of the currents and voltages on the powerline 11 to smaller signals that can safely be processed by electronic equipment. A processing device of the circuit element 67 processes the reduced signals with a method according to embodiments of the first aspect. Means for controlling a circuit breaker of the circuit element 67 control the circuit breaker 68, preferably such that the circuit breaker 68 isolates the fault immediately when the circuit element 67 locates a fault on the powerline 11, and preferably with a time delay when the fault is located further away.

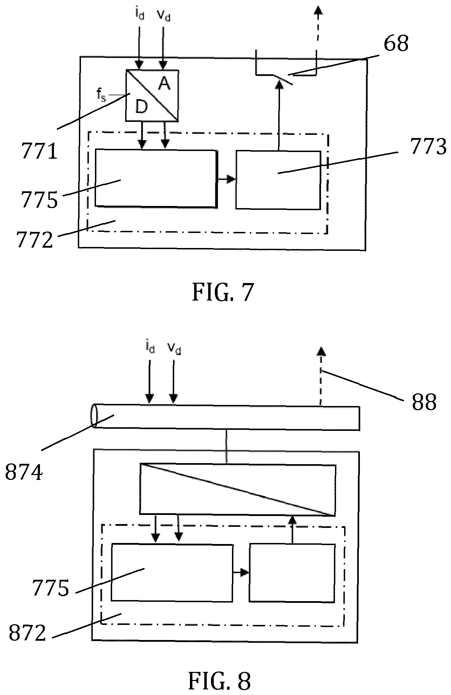

Reference is made to FIG. 7, which is a schematic representation of a circuit element according to embodiments of the second aspect of the present invention comprising a hard-wire connection. In case the circuit element comprises the hard-wired connection, time-dependent data obtained on a current and a voltage are analogue quantities, typically ranging from a root-mean square current of from 0 A to 50 A and a root-mean-square voltage of from 0 to 100 V. An analogue-to-digital converter 771 processes the time-dependent data at a sampling frequency $f_s$, thereby generating a stream of time-series data values. For instance, the sampling frequency may be between 1 kHz and 10 kHz, allowing to acquire sufficient harmonic content for performing a method according to embodiments of the first aspect to be effective. Furthermore, such a sampling frequency may be easily reached by electronic components involved in the data acquisition.

The method for determining the fault location from the time-dependent data i.e. the time-series data may be implemented in software-code and deployed on a microprocessor 772. The time-dependent data are obtained from the analogue-to-digital converter 771 by the microprocessor 772. The microprocessor 772 first corrects the time-dependent data for the conversion performed by the instrument transformer, which has reduced the magnitude of the signal. Also, the technical specification of the powerline, such as length and impedance, have been integrated in the method to be performed by the microprocessor 772, which is typically done before setting the circuit element into operation. The method for calculating the fault location is then performed in a processing device 775 on the time-dependent data. In embodiments, the method may be continuously performed: as soon as a fault is detected on the powerline, a signal is issued to a logic 773. The logic 773 decides whether the circuit breaker 68 is opened instantaneously or after a time delay: the time delay has been configured by the user before setting the circuit element 67 into operation. When the circuit breaker 68 is to be opened, the logic 773 issues the command for opening the circuit breaker, via an output, to the circuit breaker 68. Typically, the output is linked to a contact, typically an opto-coupler, that activates a so-called trip-coil of the circuit breaker 68.

Reference is made to FIG. 8, which is a schematic representation of a circuit element according to embodiments of the second aspect of the present invention comprising a process bus 874. By using the process bus 874, the circuit element receives a time-dependent voltage and current data as streams of time-series data point, i.e. sampled values. Therefore, in contrast to the previous example of a circuit element comprising a hard-wired connection, in this example, no analogue-to-digital conversion is required. Instead, a process bus interface is required that makes the microprocessor compatible with the process bus protocol. A typical process bus protocol is IEC61850-9-2. A microprocessor 872 comprises a processing device 775 for determining a fault location. Finally, the command to open the circuit breaker is sent to the process bus 874 as a numerical value: the corresponding circuit breaker is connected 88 to the process bus 874. It recognizes this command and will open to clear the fault.

According to a third aspect, the present invention relates to a converter comprising a circuit element according to embodiments of the second aspect of the present invention.

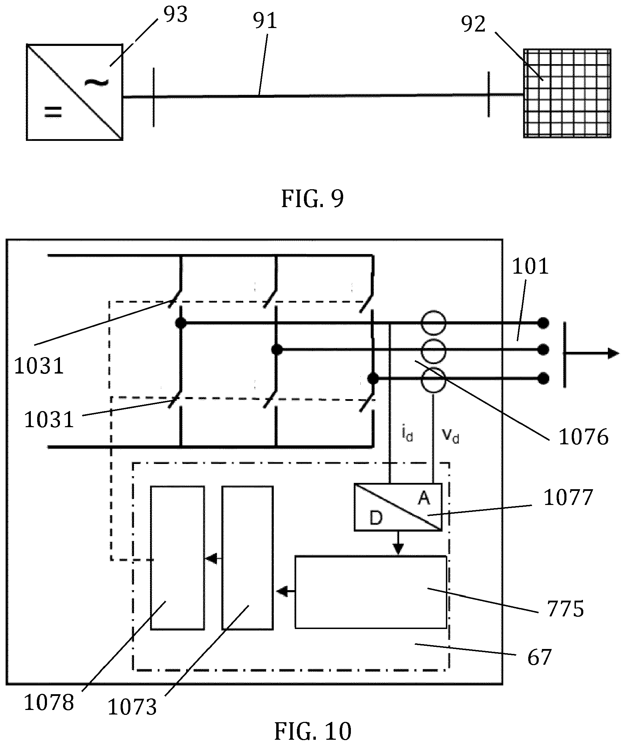

Reference is made to FIG. 9, which is a schematic representation of a circuit topology comprising an example of a power source comprising a converter 93 according to an embodiment not part of the invention, The converter is connected to a second end of a powerline 91, wherein the powerline 91 is at a first end connected to an electricity grid 92. The converter 93 comprises a circuit element according to an embodiment of the second aspect of the present invention, with the aim of selective protection of the powerline 91 connecting the power source comprising the converter 93 to the electricity grid 92. Integrating the circuit element in the converter 93 offers the benefit of, first, allowing a distance protection which ensures a great safety of supply at low costs. Second, additional costs are saved by omitting an additional circuit element, an additional instrument transformer, and an additional circuit breaker. Indeed, apparatus may be shared between the converter and the circuit element.

The circuit element obtains time-dependent data on a current through, and on a voltage on, the powerline 91, using an acquisition system of the converter. On the detection of a fault located on the powerline 91, the converter 96 stops injecting current, either instantaneously or after a time delay, thereby implements a concept of selective fault clearing of distance protection.

Reference is made to FIG. 10, which is a schematic representation of the converter. As the circuit element 67 is integrated in the converter, a method for determining a fault location may be implemented as software-code on a processing device 775 present in the converter. It obtains the time-dependent data from an acquisition system 1076 connected to the three wires of the three-phase powerline 101, and an analogue-to-digital converter 1077, that are present in the converter as they are required for the control of the power electronic switches 1031 of the converter. The sampling frequency of the analogue-to-digital converter is preferably greater than 1 kHz so that it acquires sufficient harmonics content of the electrical signal on the powerline 101. Also, the processing device 775 must comprise sufficient computational resources so that the method for determining the location of the fault can be executed in real-time.

A logic 1073 coupled with the processing device 775 decides about the response of the converter to a fault. It compares the fault location determined by the processing device 775 to a pre-set configuration of the logic 1073 and then may initiate the converter to stop injecting current, either instantaneously or with a time delay. Therefore, it sends a command to a control 1078 that then opens the power electronic switches 1031. This ultimately prevents the converter from injecting current and the fault is selectively cleared.

According to a fourth aspect, the present invention relates to a computer comprising means for carrying out the steps of the method according to embodiments of the first aspect of the present invention.

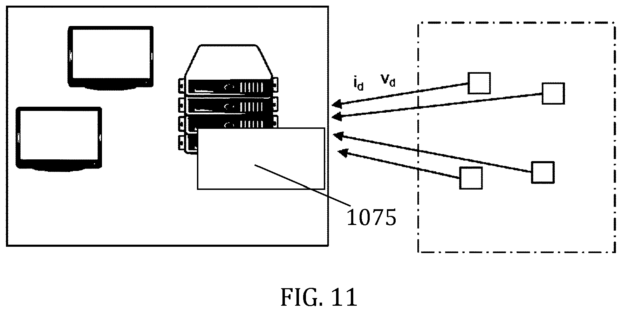

Reference is made to FIG. 11. A method according to an embodiment not part of the invention, can also be performed in a network control center (NCC). An NCC may be based on servers that gather information from powerlines. With this information, the NCC determines the state of the powerlines and presents it to a grid operator. This allows one grid operator to take decisions and control a plurality of powerlines from a distance. Advantageously, the method for determining a fault location allows a grid operator to locate faults more accurately in powerlines wherein an electrical signal for a large part is generated by a power source comprising a converter. As such, the grid operator can find and repair faults on powerlines quicker, which reduces the duration of power-outages and makes the maintenance more efficient.

The method for determining a fault location may be implemented as software-code and deployed on a server of the NCC and executed using remote time-dependent data on a voltage and a current obtained at several locations on a powerline, or on a plurality of powerlines, and present the fault locations determined with the method to the grid operator.

The method on the NCC can either operate online or offline.

Operating online, the time-dependent data from several locations are continuously read from a wide-area network and instantaneously processed. As soon as a fault occurs the grid operator receives, with a delay of a possibly only few seconds, the fault locations determined by the method. The time delay may in general be limited by the transmission rate of the wide area network.

Operating offline, data may be processed from several locations that have been recorded during historical events. This may help grid operators to analyse faults in powerlines wherein an electrical signal for a large part is generated by a power source comprising a converter. Because of a high accuracy that may be reached, the method may even determine fault locations that had not been discovered yet.

It is to be understood that although preferred embodiments, specific constructions and configurations, as well as materials, have been discussed herein for devices according to the present invention, various changes or modifications in form and detail may be made without departing from the scope and spirit of this invention. For example, any formulas given above are merely representative of procedures that may be used. Functionality may be added or deleted from the block diagrams and operations may be interchanged among functional blocks. Steps may be added or deleted to methods described within the scope of the present invention.

**Claims**

1. A method for determining a location of a fault (16), having a fault type, on a powerline (11) that is at a first end connected to an electricity grid (12) and that is at a second end connected to a power source for applying an alternating electrical signal with a fundamental frequency to the powerline (11), the method comprising:

   a) obtaining, using a measuring device (15) at a measurement location on the powerline (11), time-dependent data of a voltage on the powerline (11) and of a current through the powerline (11) at the measurement location, wherein the time-dependent data is obtained during a time period after fault inception, wherein the time-dependent data comprises fundamental and nonfundamental frequency waveform components, and wherein a duration of the time period is at least a duration of one full period of the fundamental frequency,
   b) removing the fundamental frequency components from the time-dependent data,
   c) calculating, from the time-dependent data, a virtual fault inductance for at least two different potential fault locations, by inputting the time-dependent data into an equivalent circuit model suitable for the fault type, and by means of time-domain calculations on the nonfundamental frequency waveform components, and
   d) deriving, from the virtual fault inductance for each of the potential fault locations, a location on the line at which the virtual fault inductance is substantially zero.

2. The method according to claim 1, wherein the time-dependent data comprises time series data of the voltage and the current acquired over the time period, and wherein the time-domain calculations of step b comprise discrete time-domain calculations.

3. The method according to any of the previous claims, wherein deriving the location of the fault (16) comprises fitting a fit curve to the virtual fault inductance as a function of the potential fault location on the line, thereby yielding the location at which the fault inductance equals substantially zero.

4. The method according to any of the previous claims, wherein in step a) the time-dependent data of three phases of the voltage and the current is obtained.

5. The method according to any of the previous claims, wherein the time-dependent data comprises a time resolution of at least 1 ms.

6. The method according to any of the previous claims, wherein the time-dependent data comprises recorded time-dependent data from historical events.

7. The method according to any of the previous claims, wherein the power source comprises a converter (13).

8. The method according to claim 7, wherein the converter (13) comprises the measuring device.

9. A circuit element (67) for determining a location of a fault (16), having a fault type, on a powerline (11) connected to an electricity grid (12), the circuit element comprising:

an acquisition system configured for obtaining time-dependent data of a voltage on the powerline and of a current through the powerline at a measurement location on the powerline, wherein the time-dependent data is obtained during a time period after fault inception, wherein the time-dependent data comprises fundamental and nonfundamental frequency waveform components, and wherein a duration of the time period is at least a duration of one full period of the fundamental frequency,
a means configured for determining the fault type, and
a processing device (775) configured for performing the steps of:

removing the fundamental frequency components from the time-dependent data,
calculating, from the time-dependent data, a virtual fault inductance for at least two different potential fault locations, by inputting the time-dependent data into an equivalent circuit model suitable for the fault type, and by means of time-domain calculations on the nonfundamental frequency waveform components, and
deriving, from the virtual fault inductance for each of the potential fault locations, a location on the line at which the virtual fault inductance is substantially zero.

10. The circuit element (67) according to claim 9, comprising means for controlling a circuit breaker (68).

11. The circuit element according to claim 9 or 10, comprising a communication system for communicating a determined location of the fault.

12. The circuit element according to claim 11, comprising a processor for determining the fault location using at least two determined locations of the fault.

13. A converter (93) comprising the circuit element of any of claims 9 to 12.

14. A computer comprising means for carrying out the steps of the method of any of claims 1 to 8.

15. The computer according to claim 14, comprising means for communicating with a circuit element (67) according to any of claims 9 to 12.

**Patentansprüche**

1. Ein Verfahren zum Bestimmen eines Ortes eines Fehlers (16), der einen Fehlertyp aufweist, auf einer Stromleitung (11), die an einem ersten Ende mit einem Elektrizitätsnetz (12) verbunden ist und die an einem zweiten Ende mit einer Stromquelle zum Anlegen eines elektrischen Wechselsignals mit einer Grundfrequenz an die Stromleitung (11) verbunden ist, wobei das Verfahren umfasst:

a) Erhalten, unter Verwendung einer Messvorrichtung (15) an einem Messort auf der Stromleitung (11), von zeitabhängigen Daten einer Spannung auf der Stromleitung (11) und eines Stroms durch die Stromleitung (11) an dem Messort, wobei die zeitabhängigen Daten während einer Zeitperiode nach Fehlerbeginn erhalten werden, wobei die zeitabhängigen Daten Grund- und Nicht-Grundfrequenz-Wellenformkomponenten umfassen, und wobei eine Dauer der Zeitperiode mindestens eine Dauer einer vollen Periode der Grundfrequenz ist,
b) Entfernen der Grundfrequenzkomponenten aus den zeitabhängigen Daten,
c) Berechnen, anhand der zeitabhängigen Daten, einer virtuellen Fehlerinduktivität für mindestens zwei verschiedene potentielle Fehlerorte durch Eingeben der zeitabhängigen Daten in ein für den Fehlertyp geeignetes Ersatzschaltungsmodell und mittels Zeitbereichsberechnungen an den Nicht-Grundfrequenz-Wellenformkomponenten, und
d) Ableiten, anhand der virtuellen Fehlerinduktivität für jeden der potentiellen Fehlerorte, eines Ortes auf der Leitung, an dem die virtuelle Fehlerinduktivität im Wesentlichen Null beträgt.

2. Das Verfahren nach Anspruch 1, wobei die zeitabhängigen Daten Zeitreihendaten der Spannung und des Stroms umfassen, die über die Zeitperiode erfasst wurden, und wobei die Zeitbereichsberechnungen aus Schritt b diskrete Zeitbereichsberechnungen umfassen.

3. Das Verfahren nach einem der vorstehenden Ansprüche, wobei das Ableiten des Ortes des Fehlers (16) das Angleichen einer Angleichungskurve an die virtuelle Fehlerinduktivität in Abhängigkeit von dem potentiellen Fehlerort auf der Leitung umfasst, wodurch sich der Ort ergibt, an dem die Fehlerinduktivität im Wesentlichen gleich Null ist.

4. Das Verfahren nach einem der vorstehenden Ansprüche, wobei in Schritt a) die zeitabhängigen Daten von drei Phasen der Spannung und des Stroms erhalten werden.

5. Das Verfahren nach einem der vorstehenden Ansprüche, wobei die zeitabhängigen Daten eine Zeitauflösung von mindestens 1 ms umfassen.

6. Das Verfahren nach einem der vorstehenden Ansprüche, wobei die zeitabhängigen Daten aufgezeichnete zeitabhängige Daten von historischen Ereignissen umfassen.

7. Das Verfahren nach einem der vorstehenden Ansprüche, wobei die Stromquelle einen Konverter (13) umfasst.

8. Das Verfahren nach Anspruch 7, wobei der Konverter (13) die Messvorrichtung umfasst.

9. Ein Schaltungselement (67) zum Bestimmen eines Ortes eines Fehlers (16), der einen Fehlertyp aufweist, auf einer Stromleitung (11), die mit einem Elektrizitätsnetz (12) verbunden ist, wobei das Schaltungselement umfasst:

ein Erfassungssystem, das dafür konfiguriert ist, zeitabhängige Daten einer Spannung auf der Stromleitung und eines Stroms durch die Stromleitung an einem Messort auf der Stromleitung zu erhalten, wobei die zeitabhängigen Daten während einer Zeitperiode nach Fehlerbeginn erhalten werden, wobei die zeitabhängigen Daten Grund- und Nicht-Grundfrequenz-Wellenformkomponenten umfassen, und wobei eine Dauer der Zeitperiode mindestens eine Dauer einer vollen Periode der Grundfrequenz ist,
ein Mittel, das dafür konfiguriert ist, den Fehlertyp zu bestimmen, und
eine Verarbeitungsvorrichtung (775), die dafür konfiguriert ist, die folgenden Schritte durchzuführen:

Entfernen der Grundfrequenzkomponenten aus den zeitabhängigen Daten,
Berechnen, anhand der zeitabhängigen Daten, einer virtuellen Fehlerinduktivität für mindestens zwei verschiedene potentielle Fehlerorte durch Eingeben der zeitabhängigen Daten in ein für den Fehlertyp geeignetes Ersatzschaltungsmodell und mittels Zeitbereichsberechnungen an den Nicht-Grundfrequenz-Wellenformkomponenten, und
Ableiten, anhand der virtuellen Fehlerinduktivität für jeden der potentiellen Fehlerorte, eines Ortes auf der Leitung, an dem die virtuelle Fehlerinduktivität im Wesentlichen Null beträgt.

10. Das Schaltungselement (67) nach Anspruch 9, das Mittel zum Steuern eines Schutzschalters (68) umfasst.

11. Das Schaltungselement nach Anspruch 9 oder 10, das ein Kommunikationssystem zum Kommunizieren eines bestimmten Ortes des Fehlers umfasst.

12. Das Schaltungselement nach Anspruch 11, das einen Prozessor zum Bestimmen des Fehlerortes unter Verwendung von mindestens zwei bestimmten Orten des Fehlers umfasst.

13. Ein Konverter (93), der das Schaltungselement nach einem der Ansprüche 9 bis 12 umfasst.

14. Ein Computer, der Mittel zum Ausführen der Schritte des Verfahrens nach einem der Ansprüche 1 bis 8 umfasst.

15. Ein Computer nach Anspruch 14, der Mittel zum Kommunizieren mit einem Schaltungselement (67) nach einem der Ansprüche 9 bis 12 umfasst.

**Revendications**

1. Une méthode pour déterminer un emplacement d'un défaut (16), ayant un type de défaut, sur une ligne électrique (11) qui est à une première extrémité connectée à un réseau électrique (12) et qui est à une seconde extrémité connectée à une source d'énergie pour appliquer un signal électrique alternatif avec une fréquence fondamentale à la ligne électrique (11), la méthode comprenant :

   a) l'obtention, à l'aide d'un dispositif de mesure (15) à un emplacement de mesure sur la ligne électrique (11), de données dépendantes du temps d'une tension sur la ligne électrique (11) et d'un courant traversant la ligne électrique (11) à l'emplacement de mesure, dans lequel les données dépendantes du temps sont obtenues pendant une période de temps après l'apparition du défaut, dans lequel les données dépendantes du temps comprennent des composants d'onde de fréquence fondamentale et non fondamentale, et dans lequel une durée de la période de temps est au moins une durée d'une période complète de la fréquence fondamentale,
   b) l'élimination des composants de fréquence fondamentale des données dépendantes du temps,
   c) le calcul, à partir des données dépendantes du temps, d'une inductance de défaut virtuelle pour au moins deux emplacements de défaut potentiels différents, en introduisant les données dépendantes du temps dans un modèle de circuit équivalent adapté au type de défaut, et au moyen de calculs en domaine temporel sur les composants d'onde de fréquence non fondamentale, et
   d) la dérivation, à partir de l'inductance de défaut virtuelle pour chacun des emplacements de défaut potentiels, d'un emplacement sur la ligne où l'inductance de défaut virtuelle est sensiblement nulle.

2. La méthode selon la revendication 1, dans laquelle les données dépendantes du temps comprennent des données de séries temporelles de la tension et du courant acquises sur la période de temps, et dans laquelle les calculs en domaine temporel de l'étape b comprennent des calculs discrets en domaine temporel.

3. La méthode selon l'une quelconque des revendications précédentes, dans laquelle la dérivation de l'emplacement du défaut (16) comprend l'ajustement d'une courbe d'ajustement à l'inductance de défaut virtuelle en fonction de l'emplacement de défaut potentiel sur la ligne, ce qui donne l'emplacement où l'inductance de défaut est sensiblement nulle.

4. La méthode selon l'une quelconque des revendications précédentes, dans laquelle à l'étape a, les données dépendantes du temps de trois phases de la tension et du courant sont obtenues.

5. La méthode selon l'une quelconque des revendications précédentes, dans laquelle les données dépendantes du temps comprennent une résolution temporelle d'au moins 1 ms.

6. La méthode selon l'une quelconque des revendications précédentes, dans laquelle les données dépendantes du temps comprennent des données dépendantes du temps enregistrées à partir d'événements historiques.

7. La méthode selon l'une quelconque des revendications précédentes, dans laquelle la source d'énergie comprend un convertisseur (13).

8. La méthode selon la revendication 7, dans laquelle ledit convertisseur (13) comprend le dispositif de mesure.

9. Un élément de circuit (67) pour déterminer un emplacement d'un défaut (16), ayant un type de défaut, sur une ligne électrique (11) connectée à un réseau électrique (12), ledit élément de circuit comprenant :

   un système d'acquisition configuré pour obtenir des données dépendantes du temps d'une tension sur la ligne électrique et d'un courant traversant la ligne électrique à un emplacement de mesure sur la ligne électrique, dans lequel les données dépendantes du temps sont obtenues pendant une période de temps après l'apparition du défaut, dans lequel les données dépendantes du temps comprennent des composants d'onde de fréquence fondamentale et non fondamentale, et dans lequel une durée de la période de temps est au moins une durée d'une période complète de la fréquence fondamentale,
   un moyen configuré pour déterminer le type de défaut, et
   un dispositif de traitement (775) configuré pour effectuer les étapes de :

      suppression des composants de fréquence fondamentale des données dépendantes du temps,
      calcul, à partir des données dépendantes du temps, d'une inductance de défaut virtuelle pour au moins deux emplacements de défaut potentiels différents, en introduisant les données dépendantes du temps dans un modèle de circuit équivalent adapté au type de défaut,
et au moyen de calculs en domaine temporel sur les composants d'onde de fréquence non fondamentale, et dérivation, à partir de l'inductance de défaut virtuelle pour chacun des emplacements de défaut potentiels, d'un emplacement sur la ligne où l'inductance de défaut virtuelle est sensiblement nulle.

10. L'élément de circuit (67) selon la revendication 9, comprenant des moyens pour contrôler un disjoncteur (68) .

11. L'élément de circuit selon la revendication 9 ou 10, comprenant un système de communication pour communiquer un emplacement déterminé du défaut.

12. L'élément de circuit selon la revendication 11, comprenant un processeur pour déterminer l'emplacement du défaut en utilisant au moins deux emplacements déterminés du défaut.

13. Un convertisseur (93) comprenant l'élément de circuit de l'une quelconque des revendications 9 à 12.

14. Un ordinateur comprenant des moyens pour exécuter les étapes de la méthode de l'une quelconque des revendications 1 à 8.

15. L'ordinateur selon la revendication 14, comprenant des moyens pour communiquer avec un élément de circuit (67) selon l'une quelconque des revendications 9 à 12.

FIG. 1

FIG. 2

FIG. 3A

FIG. 3B

**FIG. 4**

**FIG. 5**

**FIG. 6**

FIG. 7

FIG. 8

FIG. 9

FIG. 10

FIG. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2015145170 A

- US 2018203056 A

### Non-patent literature cited in the description

- **C. BRANTL et al.** The Application of Line Protection Relays in High Voltage AC Transmission Grids Considering the Capabilities and Limitations of Connected MMCs. *Developments in Power System Protection,* 2020, 1-6

- **A. HOOSHYAR et al.** Distance Protection of Lines Emanating from Full-Scale Converter-Interfaced Renewable Energy Power Plants-Part I: Problem Statement. *IEEE Trans. Power Deliv.,* 2015, vol. 30 (4), 1770-1780
- **E. MARTINEZ et al.** Effects of Type-4 Wind Turbine on present protection relaying algorithms. *Ninth Protection, Automation and Control (PAC) World Conference,* 2018